# EUROPEAN PATENT APPLICATION

(11) **EP 2 333 589 A1**
(43) Date of publication of application: **15.06.2011**
(21) Application number: 09809448.5
(22) Date of filing: 04.06.2009
(51) Int. Cl.: G02B 1/11, B23K 26/00, B23K 26/08, B23K 26/36, G03F 7/20, H01L 33/00

(54) **MANUFACTURING METHOD FOR PATTERN-FORMING BODY AND ELECTROMAGNETIC BEAM PROCESSING APPARATUS**

(30) Priority: 29.08.2008 JP 2008221901
(71) Applicant: FUJIFILM Corporation, Tokyo 106-8620 (JP)
(72) Inventor: USAMI, Yoshihisa, Ashigarakami-gun Kanagawa 258-8577 (JP)
(74) Representative: Klunker . Schmitt-Nilson . Hirsch
(86) International application number: PCT/JP2009/002513
(87) International publication number: WO 2010/023790

(57) **Abstract**

To provide a manufacturing method for a patterned member, by which a dotted pattern can be readily formed without deforming the shape of pits. There is provided a method for manufacturing a patterned member on which a dotted pattern is formed. This manufacturing method comprises: a preparation step of preparing a substrate having a photoresist layer which undergoes a change in shape when it is illuminated and hence heated with an electromagnetic beam; and an exposure step of illuminating and scanning the photoresist layer with the electromagnetic beam to remove a part of the photoresist layer, wherein in the exposure step, an emission time of the electromagnetic beam is adjusted to fall within 10-40% of a scanning time corresponding to a pitch of a plurality of pits formed on the photoresist layer in a scanning direction.

## Description

### TECHNICAL FIELD

The present invention relates to a method for manufacturing a patterned member having a fine asperity pattern and a processing apparatus using an electromagnetic beam for this manufacturing method.

### BACKGROUND ART

In a light emitting element such as an LED, a fluorescent lamp, an EL (electro-luminescence) element, and a plasma display, an outer sheath member of a luminous body is formed by a clear lens, a protecting film or a glass tube, and light is emitted to the outside through the surface of the outer sheath member.

In general, a refractive index of this transparent outer sheath member is much greater than the refractive index of air. Therefore, when the light is emitted to the outside from the outer sheath member, reflection occurs at an interface between the outer sheath member and the air. In some cases, according to an angle of reflection of the light, the light reflected at the interface is not emitted from the inside to the outside of the outer sheath member, and the light is converted into heat in the end. This can also be said of a light emitting surface of an LED element comprising a semiconductor.

As a technique for preventing a loss of light due to this interface reflection, there is known a method for providing a fine asperity structure on a surface such as a light emitting surface (*e.g*., see Patent Document 1). It is preferable that when such a fine asperity structure is provided on the light emitting surface to prevent reflection of light at the interface, fine asperities are formed in a dense and precipitous manner.

Further, as a method for simply and accurately forming the above fine asperity structure, as disclosed in Patent Document 2, there is known a method for forming pits by irradiating a heat reactive type material (i.e., a material which undergoes a change in shape when it is illuminated and hence heated with an electromagnetic beam) with a laser beam.
Patent Document 1: Japanese Laid-open Patent Application, Publication No. 2003-174191
Patent Document 2: Japanese Laid-open Patent Application, Publication No. 2007-216263

### SUMMARY OF INVENTION

### TECHNICAL PROBLEM

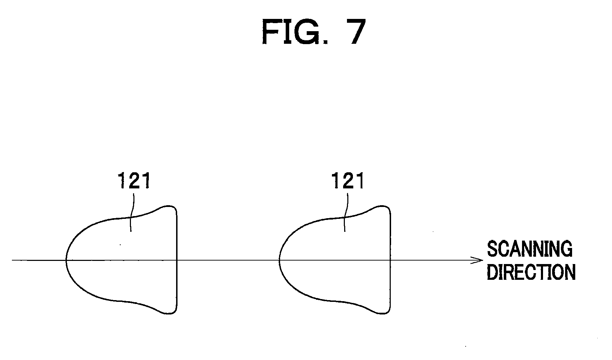

However, when a photoresist layer comprising a heat reactive type material is processed by scanning it with a laser beam, heat transfers differently at a portion of the photoresist layer where the irradiation of the laser beam is initiated and at a portion of the photoresist layer where the irradiation of the laser beam is completed. Accordingly, distortion may occur on the shape of a pit formed by removing a photoresist material to form a pit. To be more specific, as seen in FIG. 7, since heat does not stay near the laser beam irradiation starting point, a pit 121 has a narrow shape at an upstream end of a scanning direction. However, since heat stays near the laser beam irradiation end point, the photoresist layer is removed to a larger extent at a region near the end point compared with a region near the starting point. As a result, the obtained pit becomes wider toward downstream in the scanning direction.

In view of the above, the present invention seeks to provide a manufacturing method for a patterned member and a processing apparatus using an electromagnetic beam, by which a dotted pattern can be readily formed without distortion of pits.

### SOLUTION TO PROBLEM

According to the present invention which solves the aforementioned problem, there is provided a method for manufacturing a patterned member, on which a dotted pattern is formed, comprising: a preparation step of preparing a substrate having a photoresist layer which undergoes a change in shape when it is illuminated and hence heated with an electromagnetic beam; and an exposure step of illuminating and scanning the photoresist layer with the electromagnetic beam to remove a part of the photoresist layer, wherein in the exposure step, an emission time of the electromagnetic beam is adjusted to fall within 10-40% of a scanning time corresponding to a pitch of a plurality of pits to be formed on the photoresist layer in a scanning direction.

In this way, the electromagnetic beam is emitted for a period of time that is adjusted to fall within the range of 10-40% of a scanning time corresponding to a pitch of a plurality of pits to be formed on the photoresist layer in the scanning direction. This makes it possible to prevent heat from staying in the photoresist layer and thus to remove the photoresist material so as to form dot-like pits. In order to obtain the necessary quantity of heat for removal of the photoresist material, the output of the electromagnetic beam is adjusted where necessary in accordance with the emission time. Herein, the term "to emit" or "emission" indicates that the output of the electromagnetic beam is increased to such an extent that the photoresist layer undergoes a change of shape according to the increased heat quantity. Namely, the following two cases are included in the term "to emit" or "emission"; that is, the output of the electromagnetic beam is changed from a low-output state where emission of the electromagnetic beam does not result in a change of shape of the photoresist layer to a high-output state where the photoresist layer undergoes a change in shape by the emission of the electromagnetic beam, and the output of the electromagnetic beam is changed from a non-emission state where no electromagnetic beam is emitted to an emission state where the electromagnetic beam is emitted.

In the above manufacturing method, it is preferable that the photoresist layer is scanned with the electromagnetic beam at a liner velocity in the range of 6-200 m/s. This is because increasing the linear velocity of the electromagnetic beam up to an appropriate value can prevent heat from staying in the photoresist material.

The above manufacturing method may further comprise, after the exposure step, an etching step of etching the substrate using the photoresist layer as a mask. This makes it possible to form a plurality of pits on the substrate per se in such a manner as to correspond to the plurality of dot-like pits of the photoresist layer.

The above manufacturing method may further comprise the following steps performed after the exposure step: a film formation step of forming a film on the substrate at positions where the substrate is exposed to view through a plurality of pits of the photoresist layer; and a removal step of removing the photoresist layer. By this manufacturing method, it is also possible to form an asperity pattern on the substrate using a film having a dotted pattern formed on the substrate.

It is preferable that the thickness of the photoresist layer is set in the range of 1-10000 nm. Further, it is preferable that the photoresist layer comprises at least one dye selected from a group consisting of monomechine cyanine dyes, monomechine oxonol dyes, phthalocyanine dyes, azo dyes, azo-metal complex dyes, porphyrin dyes, arylidene dyes, coumarin dyes, azole derivatives, triazine derivatives, benzotriazole derivatives, 1-aminobutadiene derivatives, and quinophthalone dyes.

Further, it is also preferable that the output of the electromagnetic beam is set in the range of 4-200 mW.

According to the present invention which solves the aforementioned problem, there is provided a processing apparatus using an electromagnetic beam for manufacturing a patterned member, on which a dotted pattern is formed, comprising: a holder configured to support a substrate having a photoresist layer which undergoes a change in shape when it is illuminated and hence heated with an electromagnetic beam; a beam source configured to emit the electromagnetic beam; a scanning means configured to scan the photoresist layer with the electromagnetic beam emitted from the beam source; and a controller configured to execute a control to effect a change in an output of the electromagnetic beam emitted from the beam source, wherein the controller causes the beam to be emitted for an emission time in the range of 10-40% of a scanning time corresponding to a pitch of a plurality of pits to be formed on the photoresist layer in a scanning direction to form a plurality of dot-like pits on the photoresist layer.

With this configuration of the processing apparatus, the electromagnetic beam is emitted for an emission time that is adjusted in the range of 10-40% of a scanning time corresponding to a pitch of a plurality of pits to be formed on the photoresist layer in the scanning direction. This makes it possible to prevent heat from staying in the photoresist layer and thus to readily form dot-like pits on the photoresist layer.

### ADVANTAGEOUS EFFECTS OF INVENTION

According to the manufacturing method for a patterned member of the present invention and the processing apparatus using an electromagnetic beam of the present invention for this manufacturing method, since the electromagnetic beam is emitted for an emission time that is adjusted in the range of 10-40% of a scanning time corresponding to a pitch of a plurality of pits to be formed on the photoresist layer in the scanning direction, it is possible to prevent heat from staying in the photoresist layer and thus to readily form dot-like pits on the photoresist layer.

### BRIEF DESCRIPTION OF DRAWINGS

FIG. 1 is a top view of a silicon substrate on which are formed a plurality of LED chips, each of which is an example of a patterned member according to the present invention.
FIG. 2 is a sectional view of the silicon substrate.
FIG. 3 is a schematic diagram of a laser processing device.
FIG. 4 is a view showing the relationship between (a) shape of each pit and (b) exposure output of the laser beam along the scanning direction, when a plurality of pits are formed on the photoresist layer.
FIG. 5 includes views explaining a manufacturing method for a patterned member according to a modified embodiment, in which (a) shows an etching process, and (b) shows a photoresist layer removal process.
FIG. 6 includes views explaining a manufacturing method for a patterned member according to another modified embodiment, in which (a) shows a plating process, and (b) shows a photoresist layer removal process.
FIG. 7 shows a planar shape of each pit formed by a conventional method.

### DESCRIPTION OF EMBODIMENTS

Description will be given of a method for manufacturing a patterned member according to the present invention and a processing apparatus using an electromagnetic beam for this manufacturing method.

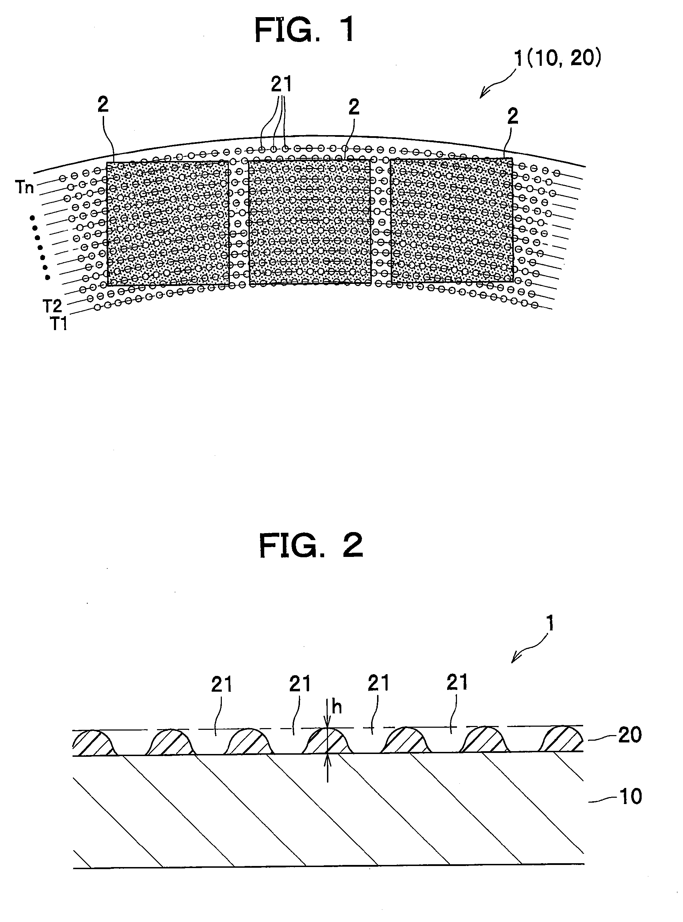

As seen in FIG. 1, a workpiece 1 as an example of a patterned member is substantially shaped like a circular disc as a whole; the workpiece 1 has asperities formed on the surface of a silicon substrate in the process of manufacturing a plurality of LED chips 2. LED chips 2 are formed by a manufacturing technique for semiconductor circuits.

As best seen in FIG. 2, the workpiece 1 includes a substrate 10 made of silicon (illustration of the circuit is omitted), and a photoresist layer 20 provided on the substrate 10.

The photoresist layer 20 is made of a photoresist material such as light-absorbing low molecules, which undergoes a change in shape due to deformation and vaporization of the material when it is illuminated and hence heated with an electromagnetic beam such as light and X-rays, that is, a thermally deformable heat mode photoresist material. The thickness of the photoresist layer 20 is appropriately set, for example, in the range of 1-10000 nm. The lower limit of the thickness is preferably 10 nm, and more preferably 50 nm. The upper limit of the thickness is preferably 1000 nm, and more preferably 500 nm.

To form the photoresist layer 20, a substance which can act as a photoresist material is dissolved or dispersed in an appropriate solvent to prepare a coating liquid. Thereafter, the coating liquid is coated on the surface of the substrate 10 by a coating method such as spin coating, dip coating, and extrusion coating, so that the photoresist layer 20 can be formed.

A plurality of pits 21 are formed on the photoresist layer 20. As best seen in FIG. 1, these pits 21 are arranged in line along tracks T1, T2, ...Tn, which are arranged substantially along a plurality of concentric circles. The tracks T1, T2, ... Tn may be a plurality of discrete circles having different diameters, or may form a single spiral track by connecting adjacent tracks. For the purpose of effectively forming the pits 21, it is preferable that the tracks T1, T2, ... Tn form a single spiral track to enable a consecutive exposure. In the following description, the photoresist layer 20 has tracks T1, T2, ... Tn that form a single spiral track.

More specifically, it is preferable that the size of the pitch P between pits 21 is in the range of 1-10000 nm. Setting the pitch size equal to or smaller than 10000 nm as described above allows the patterned member to be used as an optical element with improved light transmittance at an interface. Setting the pitch size equal to or greater than 1 nm makes it possible to prevent adjacent pits from being connected to each other. In terms of formation of discrete pits for ensuring a sufficient land height h (see FIG. 2), it is more preferable that the size of the pitch P is equal to or greater than 10 nm. Further preferably, the size of the pitch P is equal to or greater than 50 nm, and most preferably equal to or greater than 100 nm. Further, in terms of improvement in the light transmittance at the interface, it is more preferable that the size of the pitch P is equal to or less than 5 µm. Further preferably, the size of the pitch P is equal to or less than 2 µm, and most preferably equal to or less than 1 µm.

The ratio of the height between pits (i. e., height of a land) to the film thickness of the photoresist layer 20 is preferably equal to or greater than 40%, and more preferably, equal to or greater than 60%.

As described above, since the workpiece 1 according to this embodiment is provided with an arrangement of fine pits 21 (*i.e.,* asperities) on the surface of the photoresist layer 20, light emitted from the LED chip 2 can be successfully and excellently taken out to the outside of the LED chip 2. Next, description will be given of a laser processing device as an example of a processing apparatus using an electromagnetic beam, which is used for manufacturing a workpiece 1 as an example of a patterned member, on which a dotted pattern is formed.

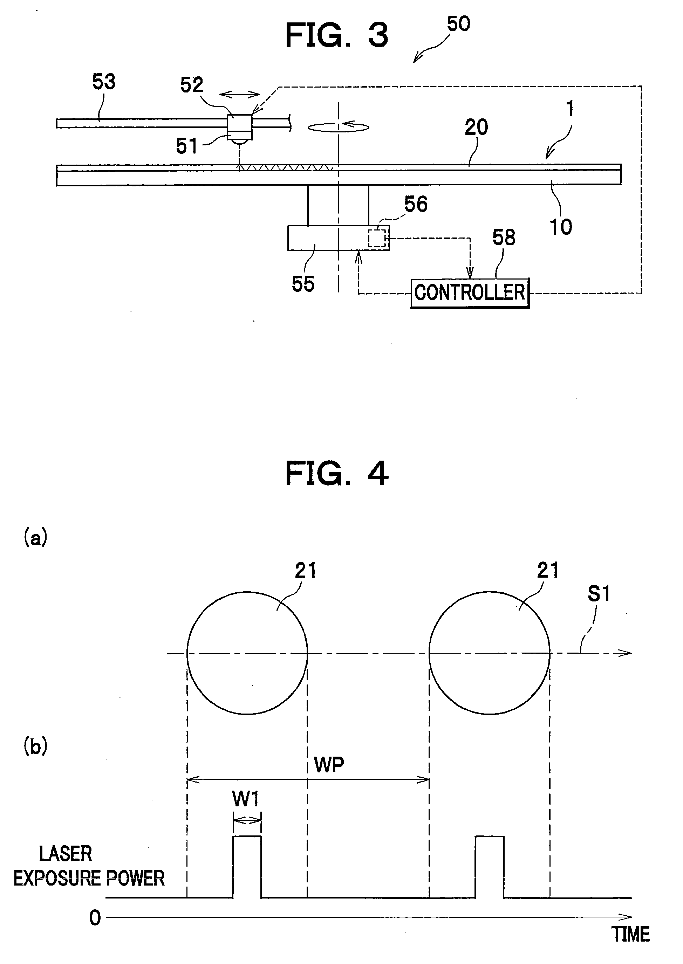

In principle, a laser processing device 50 shown in FIG. 3 is similar to a laser exposure device such as a CD-R drive, but is adapted for exposing a photoresist layer 20 according to this embodiment with light and configured to control the rotation speed of a workpiece 1 and the output of a laser beam source 51 by a controller 58.

The laser processing device 50 includes a laser beam source 51, a liner actuator 52, a guide rail 53, a rotary stage 55, an encoder 56, and a controller 58.

The laser beam source 51 is an example of a beam source for generating an electromagnetic beam. In order to form a pit 21 on the photoresist layer 20, the photoresist layer 20 may be illuminated with an electromagnetic beam having a wavelength within a light absorption wavelength region of a material constituting the photoresist layer 20, and a laser beam source 51 for generating such an electromagnetic beam may be selected in this regard. Of course, the material constituting the photoresist layer 20 may be selected based on the wavelength of the laser beam emitted from the laser beam source 51. A laser beam having a shorter wavelength is preferable in terms of accurately forming fine pits 21, and a single wavelength laser beam is preferable. For this reason, for example, a blue-violet laser diode which emits a laser beam having a wavelength of 405 nm is preferably used as the laser beam source 51.

According to the present invention, for the purpose of preventing the stay of heat, processing is performed in a short period of time with a higher output. For this reason, the output of the electromagnetic beam is preferably equal to or greater than 4 mW, more preferably equal to or greater than 6 mW, and further preferably equal to or greater than 8 mW. Further, the output of the electromagnetic beam is equal to or smaller than 200 mW, and more preferably equal to or smaller than 100 mW, and further preferably equal to or smaller than 50 mW.

The linear actuator 52 is a known device for linearly moving the laser beam source 51 in a radial direction of the workpiece 1. The guide rail 53 extends along the radial direction of the workpiece 1, and the linear actuator 52 causes the laser beam source 51 to move along the guide rail 53.

The rotary stage 55 as an example of a holder is a known device for supporting the workpiece 1 while rotating the workpiece 1. The workpiece 1 is attached to the rotary stage 55 with the center of the circular disc-shaped workpiece 1 coincident with the center of rotation of the rotary stage 55. The rotary stage 55 and the linear actuator 52 constitute an example of a scanning means.

The encoder 56 is provided on the rotary stage 55 and generates a synchronizing signal each time when the rotary stage 55 rotates for a predetermined angle. For example, the encoder 56 outputs a synchronizing signal each time when the rotary stage 55 makes one rotation. The output from the encoder 56 is input to the controller 58.

The controller 58 is a device for controlling the laser beam source 51, the linear actuator 52, and the rotary stage 55. The controller 58 controls the rotation speed of the rotary stage 55 based on the output from the encoder 56, and causes the laser beam source 51 to blink at appropriate timings. Further, for the purpose of exposing the entire surface of the workpiece 1 to the laser beam as well as for keeping an appropriate pitch between tracks, the controller 58 is configured to control the linear actuator 52 to move the laser beam source 51 in the radial direction (i. e., in a direction toward and away from the center of rotation of the substrate 10) at an appropriate speed.

Although detailed description will be omitted, the laser beam emitted from the laser beam source 51 is focused on the photoresist layer 20. To perform a focus servo during the exposure, the laser beam is illuminated at a lower output even at a part of the photoresist layer where a change of shape should not be effected. It is therefore to be noted that blinking of the laser beam indicates that the output of the laser beam is increased or decreased, and does not necessarily means that the laser beam is turned off for blinking.

As described later in detail, the controller 58 is configured to output a pulse signal to the laser beam source 51 so that the output of the laser beam is increased for a short period of time as compared with a scanning time corresponding to a pitch of the pits 21 in the scanning direction.

Description will be given of the method for manufacturing a patterned member, which is made by forming a plurality of pits 21 on the workpiece 1, using the laser processing device 50 as described above.

First, a substrate 10 on which a plurality of LED chips 2 are formed is prepared. A photoresist material is dissolved in an appropriate solvent to prepare a coating liquid, which is then coated on the surface of the substrate 10 by spin coating or the like. Accordingly, the photoresist layer 20 is formed on the substrate 10. The substrate 10 coated with the photoresist layer 20 is then supported on the rotary stage 55. At this time, the center of the substrate 10 is positioned to coincide with the center of rotation of the rotary stage 55.

Next, the controller 58 causes the rotary stage 55 to rotate at a predetermined rotation speed. The controller 58 causes the laser beam source 51 to initiate blinking of the laser beam for exposure after the rotation speed of the rotary stage 55 becomes stable. As described above, the exposure timing is determined based on the synchronizing signal input from the encoder 56.

By this exposure process, the photoresist material vaporizes from the photoresist layer 20 only at positions where the laser beam emitted at a higher laser-output strikes, and pits 21 are formed on the photoresist layer 20.

As best seen in FIG. 4, in the exposure process, the period of time during which the controller 58 causes the laser beam source 51 to emit the laser beam (*i.e.*, strictly speaking, in this embodiment, the output of the laser beam is changed from a low-output state to a high-output state where a change of shape can be effected on the photoresist layer 20; hereinafter this action is simply referred to as "emission") is adjusted about 15% if the scanning time corresponding to a pitch of pits to be formed is supposed to be 100%. This ratio is referred to as a "duty cycle" in this specification. To be more specific, if a laser beam scans along a scanning path S 1 as shown in FIG. 4 and the time required for the laser beam to move from the upstream end of one pit 21 to the upstream end of the next pit 21 is WP, the emission time corresponding to the time WP is represented by 100% duty cycle. According to this embodiment, the laser beam source 51 actually emits the laser beam for the time W1, which corresponds to about 15% duty cycle.

The duty cycle for emission with respect to the size of the pit 21 to be formed is preferably in the range of 10-40%. In terms of preventing the stay of heat in the photoresist layer 20 and thus forming dot-like pits 21, the duty cycle equal to or less than 35% is more preferable, and the duty cycle equal to or less than 25% is further preferable.

It is to be noted that a very short period of time is required before the output of the laser beam increases to a predetermined value. For this reason, in terms of processing the pits 21 with a sufficiently higher laser power, the duty cycle equal to or more than 15% is more preferable, and the duty cycle equal to or more than 20% is further preferable.

The linear velocity for moving the photoresist layer 20 relative to the laser beam for scanning the photoresist layer 20 with the laser beam is preferably in the range of 6-200 m/s. In terms of swiftly raising the output of the laser beam with respect to the movement of the photoresist layer to form a pit 21 having a precipitous edge, the slower liner velocity is better and the linear velocity equal to or less than 150 m/s is more preferable, and the linear velocity equal to or less than 100 m/s is further preferable. On the contrary, in terms of preventing the stay of heat in the photoresist layer 20 and thus forming dot-like pits 21, the higher linear velocity is better and the linear velocity equal to or more than 9 m/s is more preferable, and the linear velocity equal to or more than 12 m/s is further preferable.

If the linear velocity is too high, the duty cycle may be increased or the laser power may be increased for the purpose of supplying sufficient heat to process the photoresist material.

In terms of reducing the spot size of the laser beam to form fine pits 21, it is preferable that the laser beam source 51 emits a laser beam having a shorter wavelength. For this reason, the wavelength of the laser beam is preferably equal to or less than 800 nm, and more preferably equal to or less than 700 nm, and further preferably equal to or less than 600 nm. On the contrary, in terms of preventing absorption and scattering of light by air to perform a successful and excellent laser processing, the longer wavelength of the laser beam is better. For this reason, the wavelength of the laser beam is preferably equal to or greater than 10 nm, and more preferably equal to or greater than 100 nm, and further preferably equal to or greater than 150 nm. For example, as described above, a laser beam having a wavelength of 405 nm may be used.

If the photoresist material is removed under these exposure conditions using the laser processing device 50, unnecessary heat does not stay in the photoresist layer 20 during the exposure, so that heat can be focused on an extremely small spot to blow out the photoresist layer. Accordingly, dot-like pits 21 can be formed. Since this processing is readily performed by exposure without requiring a developing process, fine and accurate processing can be performed in a simple manner.

Although the present invention has been described above with reference to one exemplary embodiment of the present invention, the present invention is not limited to the above specific embodiment and various changes and modification may be made where appropriate.

For example, according to the above embodiment, asperities are formed on the photoresist layer 20 provided on the substrate 10, so that the workpiece 1 (i.e., a patterned member as an object to be manufactured according to the present invention) has improved light transmittance at the interface. However, the photoresist layer 20 may be used as a mask, and asperities may be formed by a thin-film formation process such as etching or plating so that the asperities on the substrate 10 per se or the asperities made by the film can improve the light transmittance at the interface.

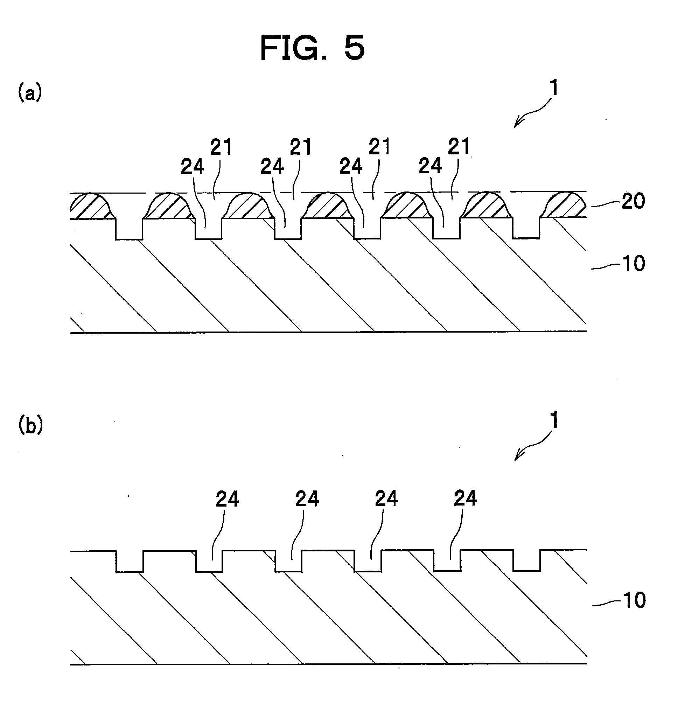

For example, as best seen in FIG. 5 (a), the substrate 10 may be etched using the photoresist layer 20, on which a plurality of pits 21 are formed, as a mask, and a plurality of pits 24 are formed on the surface of the substrate 10. Thereafter, as seen in FIG. 5 (b), the photoresist layer 20 is removed by a solvent or the like, so that a plurality of pits 24 can be directly formed on the surface of the substrate 10.

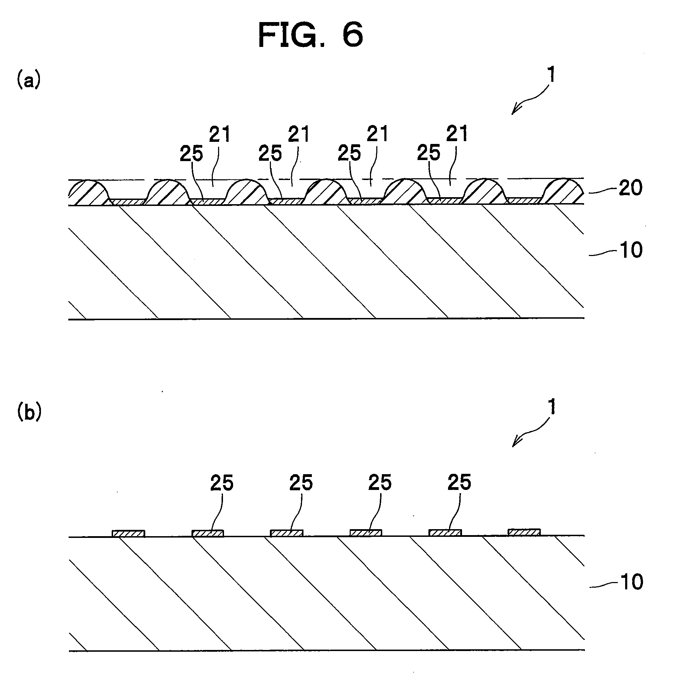

Further, the surface of the substrate 10 may be provided with conductivity (not shown) in advance, and as seen in FIG. 6 (a), plating is applied to conductive layer portions exposed to view through the pits 21. Thereafter, as seen in FIG. 6 (b), the photoresist layer 20 is removed by a solvent, so that asperities can be provided on the surface of the substrate 10 by plating.

As described above, an asperity pattern may be formed on the patterned member using a material other than the photoresist material.

Further, in the above exemplary embodiment, a plurality of pits 21 are formed on substantially concentric circular tracks by exposing the photoresist layer 20 to the laser beam while rotating the workpiece 1. However, the pits 21 may be arranged in orthogonally crossing x-y directions. In this example, the photoresist layer 20 may be scanned with the laser beam in the x-y directions using a two-axis galvanometer mirror.

Specific examples of the heat mode type photoresist material as disclosed in the above embodiment, and the conditions for processing the photoresist layer are as follows.

The heat mode type photoresist material which may be adopted includes recording materials as hitherto used generally in the recording layer of optical discs or the like; for example, recording materials such as cyanine-based, phthalocyanine-based, quinone-based, squarylium-based, azulenium-based, thiol complex salt-based, and merocyanine-based recording materials may be used for our purpose.

The photoresist layer according to the present invention may preferably be of a dye type, which contains a dye as a photoresist material.

Therefore, the photoresist material contained in the photoresist layer may be selected from dyes or other organic compounds. It is to be understood that the photoresist material is not limited to organic material; that is, an inorganic material or a composite material of organic and inorganic materials may also be employed. With the organic materials, however, the coating process for forming a film can be performed easily by spin coating or spraying, and a material having a lower transition temperature is readily available; thus, the organic materials may be preferable. Further, amongst various organic materials, dyes whose light absorption can be controlled by varying their molecular design may be preferable.

Preferred examples of material for use in the photoresist layer may include methine dyes (cyanine dyes, hemicyanine dyes, styryl dyes, oxonol dyes, merocyanine dyes, etc.), large ring dyes (phthalocyanine dyes, naphthalocyanine dyes, porphyrin dyes, etc.), azo dyes (including an azo-metal chelate dye), arylidene dyes, complex dyes, coumarin dyes, azole derivatives, triazine derivatives, 1-aminobutadiene derivatives, cinnamic acid derivatives, quinophthalone dyes, etc. Of these, methine dyes, oxonol dyes, large ring dyes, and azo dyes may be preferable.

This dye-type photoresist layer may preferably contain a dye having absorption in the range of exposure light wavelengths. Particularly, the upper limit value of an extinction coefficient k indicating the amount of light absorption may preferably be 10, more preferably 5, still more preferably 3, and most preferably 1. On the other hand, the lower limit value of the extinction coefficient k may preferably be 0.0001, more preferably 0.001, and still more preferably 0.1. Setting the extinction coefficient k within the above range preferably makes the shapes of the pits uniform.

It is to be understood, as described above, that the photoresist layer needs to have absorption of light in the range of exposure light wavelengths; with this in view, the selection of an appropriate dye and/or alteration of its structure may be made in accordance with the wavelength of the laser beam produced by the laser light source.

For example, in the case where the oscillation wavelength of the laser beam emitted from the laser light source is around 780 nm (near-infrared region), it is advantageous to select dyes such as pentamechine cyanine dyes, heptamechine oxonol dyes, pentamethine oxonol dyes, phthalocyanine dyes, and naphthalocyanine dyes. Of these, phthalocyanine dyes or pentamethine cyanine dyes may be used preferably in particular.

In the case where the oscillation wavelength of the laser beam emitted from the laser light source is around 660 nm (visible region), it is advantageous to select dyes such as trimechine cyanine dyes, pentamethine oxonol dyes, azo dyes, azo-metal complex dyes, and pyrromethene complex dyes.

Further, in the case where the oscillation wavelength of the laser beam emitted from the laser light source is around 405 nm (near-ultraviolet region), it is advantageous to select dyes such as monomechine cyanine dyes, monomechine oxonol dyes, zero-mechine merocyanine dyes, phthalocyanine dyes, azo dyes, azo-metal complex dyes, porphyrin dyes, arylidene dyes, complex dyes, coumarin dyes, azole derivatives, triazine derivatives, benzotriazole derivatives, 1-aminobutadiene derivatives, and quinophthalone dyes.

For example, in the case of triazine derivatives, the term "derivatives" indicates compounds having triazine skeleton.

Examples of preferred compounds for use in the photoresist layer (*i.e.,* as a photoresist material) are shown below in the cases where the oscillation wavelength of the laser beam emitted from the laser light source is around 780 nm, around 660 nm, and around 405 nm, respectively. Compounds given by (I-1) to (I-10) in the following chemical formulae 1, 2 are suitable in the case where the oscillation wavelength of the laser beam is around 780 nm. Compounds given by formulae (II-1) to (II-8) in the chemical formulae 3, 4 are suitable in the case where the oscillation wavelength of the laser beam is around 660 nm, and compounds given by (III-1) to (III-14) in the chemical formulae 5, 6 are suitable in the case where the oscillation wavelength of the laser beam is around 405 nm. It is to be understood that the present invention is not limited to the case where these compounds are used as the photoresist material.

Examples of photoresist material in the case of laser oscillation wavelength around 780 nm (near-infrared region),

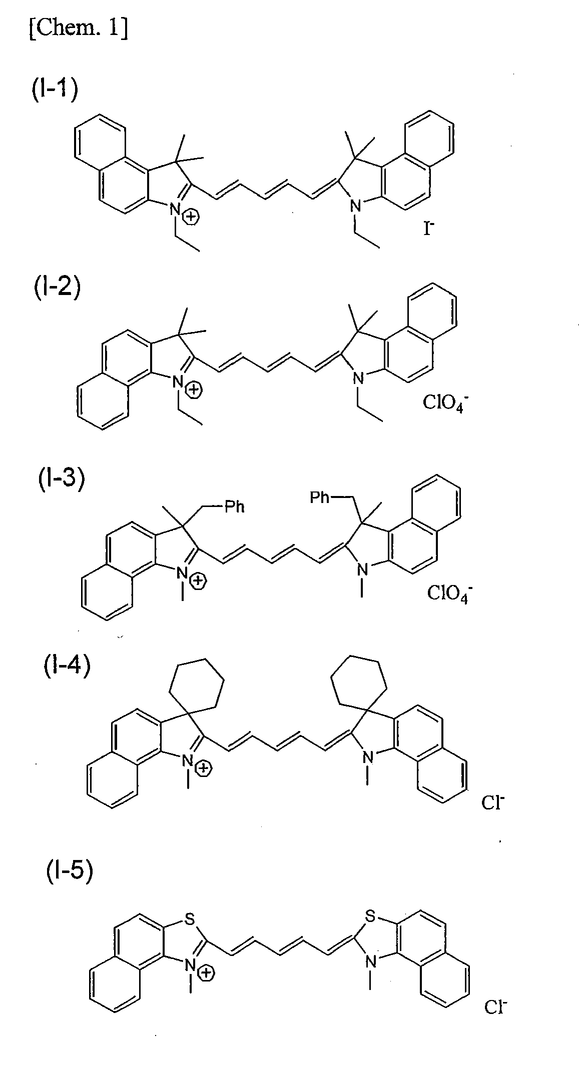

Examples of photoresist material in the case of laser oscillation wavelength around 780 nm (near-infrared region),

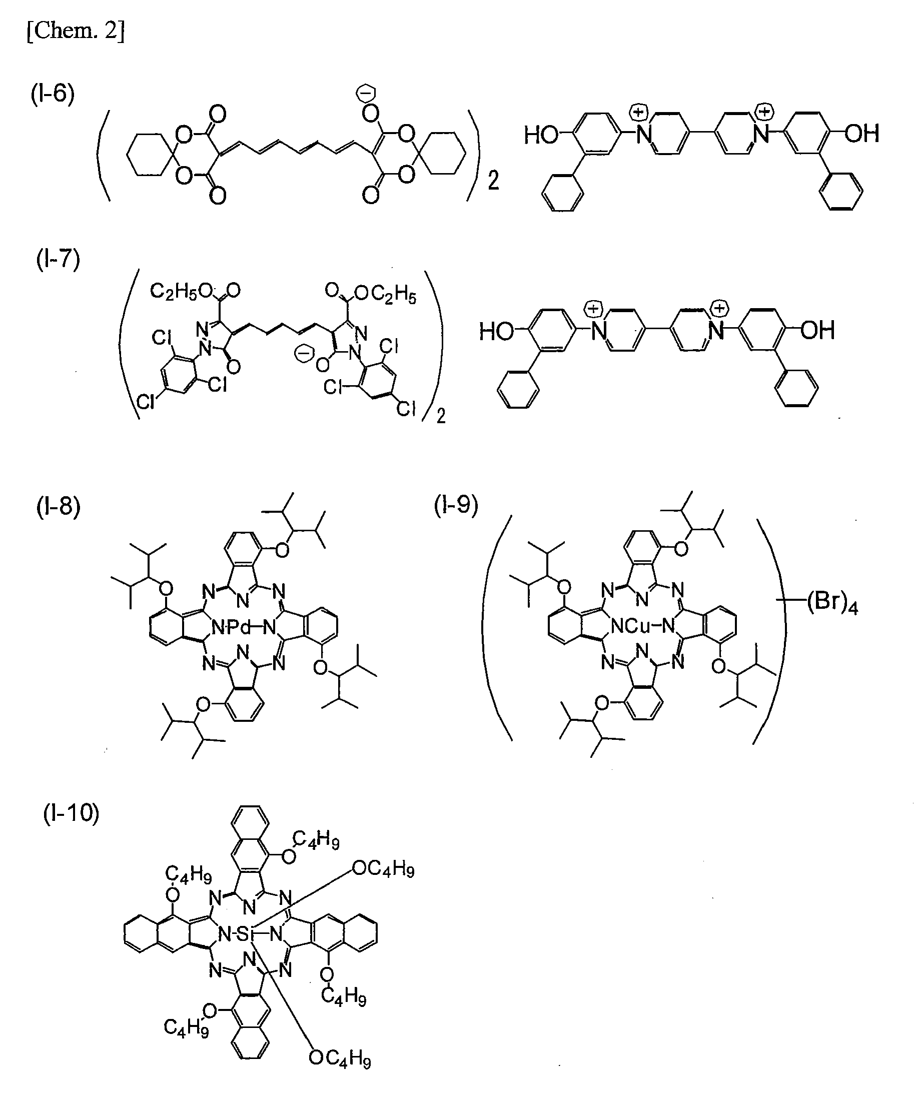

Examples of photoresist material in the case of laser oscillation wavelength around 660 nm (visible region)

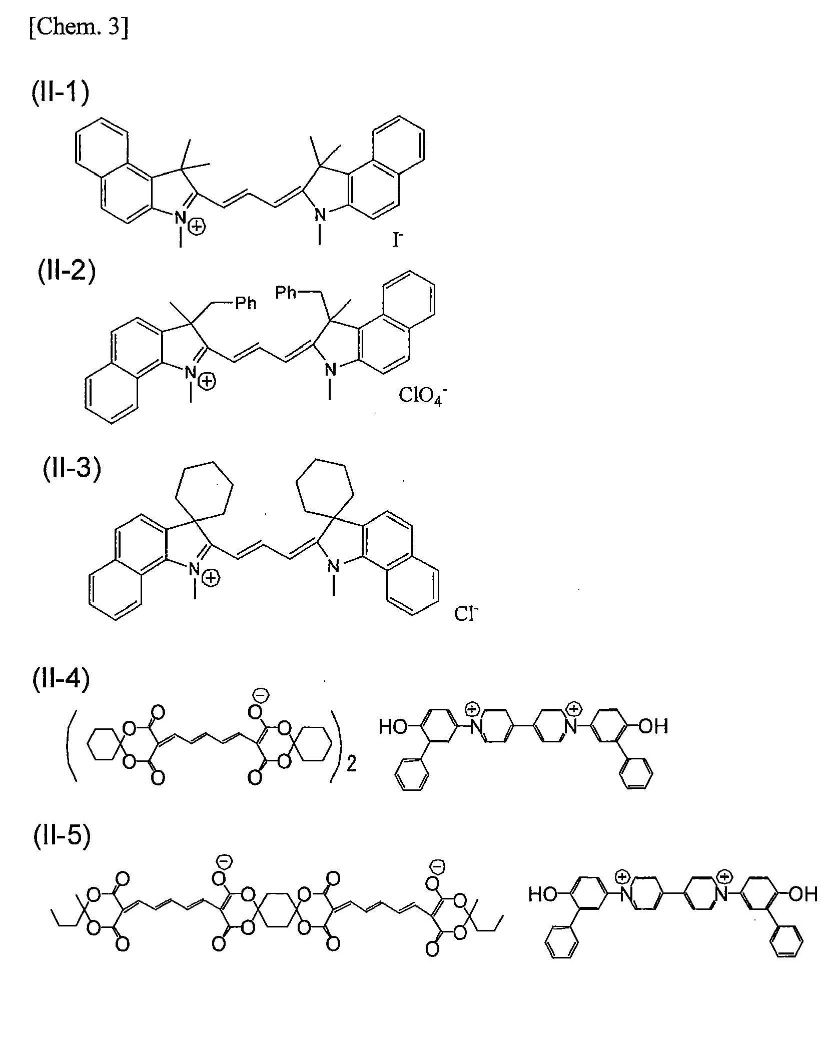

Examples of photoresist material in the case of laser oscillation wavelength around 660 nm (visible region)

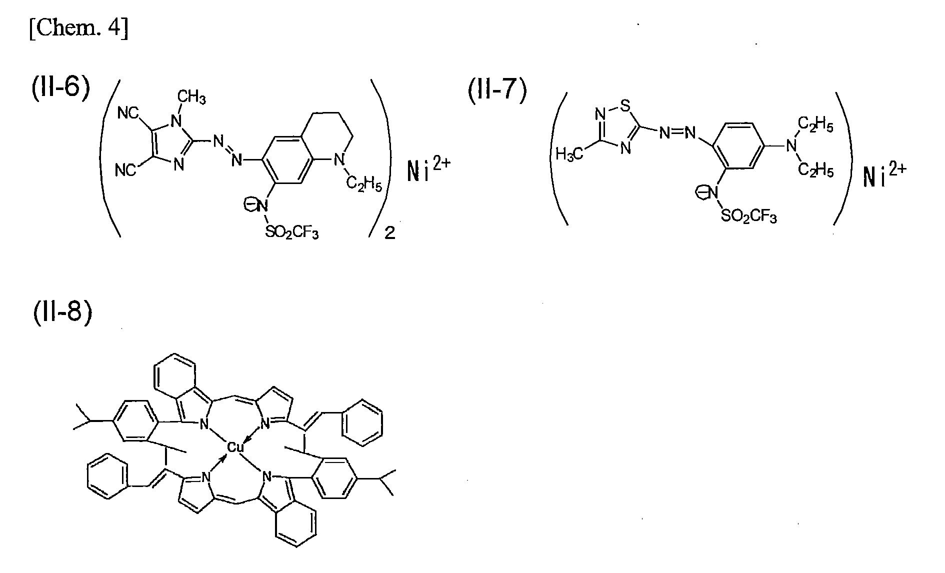

Examples of photoresist material in the case of laser oscillation wavelength around 405 nm (near-ultraviolet region)

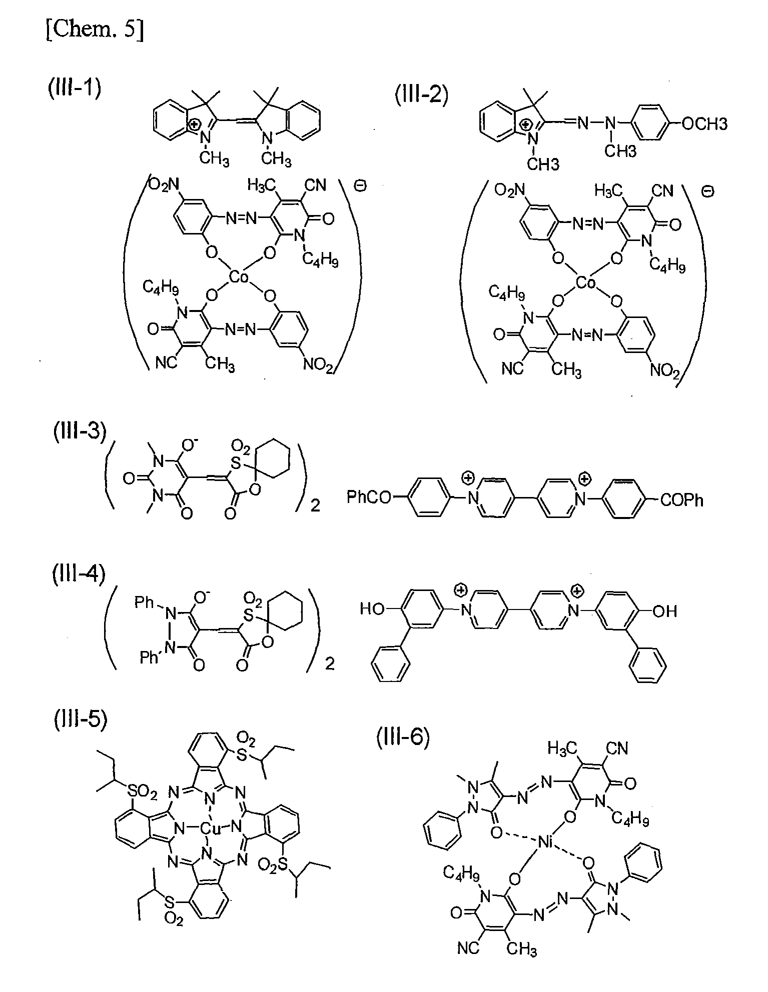

Examples of photoresist material in the case of laser oscillation wavelength around 405 nm (near-ultraviolet region)

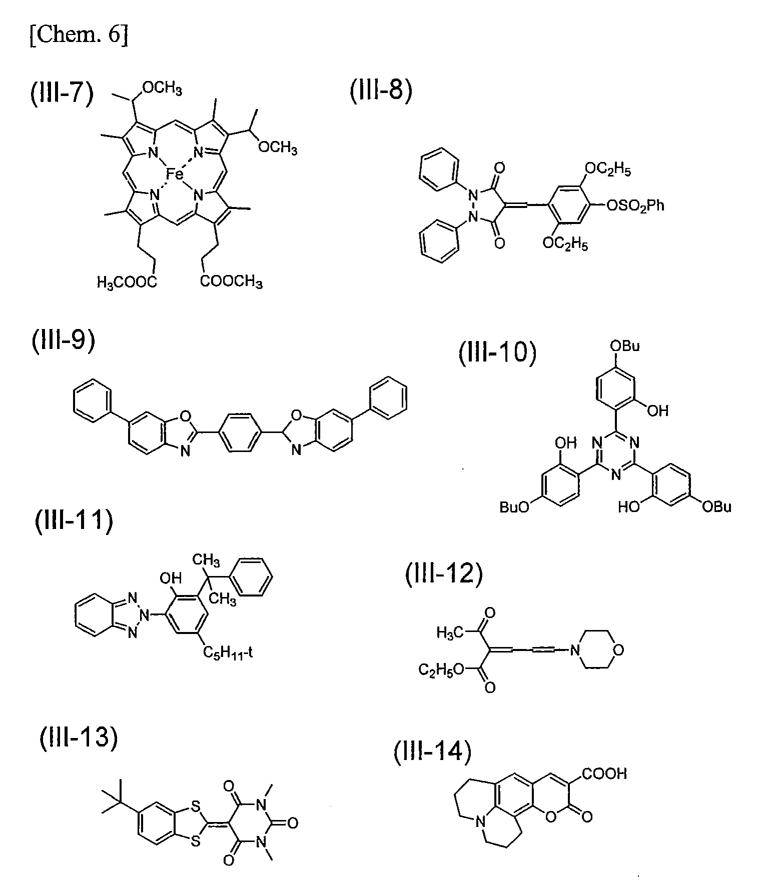

Dyes described in Japanese Laid-open Patent Applications, Publication (JP-A) Nos. 4-74690, 8-127174, 11-53758, 11-334204, 11-334205, 11-334206, 11-334207, 2000-43423, 2000-108513, and 2000-158818 can also preferably be used.

The dye-type photoresist layer may be formed by dissolving a dye in an adequate solvent along with a binding agent, etc. to prepare a coating liquid, then applying the coating liquid on a substrate to form a coating film, and thereafter drying the resulting coating film. In this process, the temperature of a surface on which the coating liquid is applied may preferably be in the range of 10-40 degrees centigrade. More preferably, the lower limit value thereof may be 15 degrees centigrade, still more preferably 20 degrees centigrade, and particularly preferably 23 degrees centigrade. Meanwhile, the upper limit value thereof may be more preferably 35 degrees centigrade, still more preferably 30 degrees centigrade, and particularly preferably 27 degrees centigrade. When the temperature of the coated surface is in the above ranges, uneven application of the coating and coating failure can be prevented, so that a thickness of the coating film can be made uniform.

Each of the upper and lower limits mentioned above may be arbitrarily combined with each other.

Here, the photoresist layer may be either mono-layered or multi-layered. In the case of the photoresist layer having a multi-layered configuration, the coating step is repeated plural times.

A concentration of the dye in the coating liquid is generally in the range of 0.01-15 mass percent, preferably in the range of 0.1-10 mass percent, more preferably in the range of 0.5-5 mass percent, and most preferably in the range of 0.5-3 mass percent.

Examples of the solvent for the coating liquid include: esters such as butyl acetate, ethyl lactate and cellosolve acetate; ketones such as methyl ethyl ketone, cyclohexanone, and methyl isobutyl ketone; chlorinated hydrocarbons such as dichloromethane, 1,2-dichloroethane and chloroform; amides such as dimethylformamide; hydrocarbons such as methylcyclohexane; ethers such as tetrahydrofuran, ethyl ether, and dioxane; alcohols such as ethanol, n-propanol, isopropanol, n-butanol, and diacetone alcohol; fluorinated solvents such as 2,2,3,3-tetrafluoropropanol; and glycol ethers such as ethylene glycol monomethyl ether, ethylene glycol monoethyl ether and propylene glycol monomethyl ether. Fluorinated solvents, glycol ethers and ketones are preferable. Particularly preferable are fluorinated solvents and glycol ethers. Further preferable are 2,2,3,3-tetrafluoropropanol and propylene glycol monomethyl ether.

Taking the solubility of the dye used in the solvents into consideration, the above solvents may be used singly or in a combination of two or more kinds thereof. Various kinds of additives such as an antioxidant, a UV absorbent, a plasticizer and a lubricant may be added in the coating liquid depending on the purpose.

Coating methods such as spray method, spin coating method, dip method, roll coat method, blade coat method, doctor roll method, doctor blade method, and screen printing method are applicable. Of these methods, the spin coating method is preferable in terms of its excellent productivity and easy controllability of the film thickness.

In order to form the photoresist layer better by the spin coating method, the dye may be dissolved in the organic solvent preferably in the range of 0.3-30 wt%, more preferably in the range of 1-20 wt%. In particular, it is preferable that the dye is dissolved in tetrafluoropropanol in the range of 1-20 wt%. It is also preferable that the thermal decomposition temperature of the photoresist material be in the range of 150-500 degrees centigrade, and more preferably in the range of 200-400 degrees centigrade.

The temperature of the coating liquid at the time of coating may preferably be in the range of 23-50 degrees centigrade, more preferably in the range of 24-40 degrees centigrade, and particularly preferably in the range of 25-30 degrees centigrade.

In the case where the coating liquid contains a binding agent, examples of the binding agent include natural organic polymers such as gelatin, cellulose derivatives, dextran, rosin and rubber; and synthetic organic polymers including hydrocarbonic resins such as polyethylene, polypropylene, polystylene and polyisobutylene, vinyl resins such as polyvinylchloride, polyvinylidene chloride and polyvinylchloride-polyvinyl acetate copolymers, acrylic resins such as polymethyl acrylate and polymethyl methacrylate, and initial condensates of thermosetting resins such as polyvinyl alcohol, chlorinated polyethylene, epoxy resin, butyral resin, rubber derivatives and phenol formaldehyde resin. In the case where the binding agent is used together as a material for the photoresist layer, the amount of the binding agent used is generally in the range of 0.01-50 times the amount of dye (mass ratio), and preferably in the range of 0.1-5 times the amount of dye (mass ratio).

In order to increase the lightfastness of the photoresist layer, various antifading agents may be contained in the photoresist layer.

In general, a singlet oxygen quencher is used for the antifading agent. As examples of such singlet oxygen quencher, those described in published documents such as patent specifications hitherto known in the art can be used.

Specific examples of such patent specifications include: Japanese Laid-open Patent Applications, Publication (JP-A) Nos. 58-175693, 59-81194, 60-18387, 60-19586, 60-19587, 60-35054, 60-36190, 60-36191, 60-44554, 60-44555, 60-44389, 60-44390, 60-54892, 60-47069, 63-209995, and 4-25492; Japanese Examined Patent Applications, Publication (JP-B) Nos. 1-38680 and 6-26028; German Patent No. 350399; and Nippon Kagaku Kaishi, October (1992), p. 1141. The use amount of the antifading agent such as a singlet oxygen quencher relative to the amount of dye is generally in the range of 0.1-50 mass percent, preferably in the range of 0.5-45 mass percent, more preferably in the range of 3-40 mass percent, and particularly preferably in the range of 5-25 mass percent.

The photoresist layer may also be formed by any film-forming method such as evaporation, sputtering and CVD, which may be selected depending on the physical properties of the material to be used therein.

The dye to be used is such that a light absorptance thereof at the wavelength of a laser beam used in the processing of a pattern of pits is higher than those at the other wavelengths.

The wavelength at which the dye exhibits the peak absorption may not necessarily fall within the range of the wavelengths of visible light, but may be within the range of the wavelengths of the ultraviolet or infrared region.

The wavelength λw of the laser beam to be emitted to form a pattern of pits may be any wavelength as long as a sufficiently high laser power is obtained. For example, in the case where a dye is used for the photoresist layer, the wavelength may preferably be 1,000 nm or less, such as 193 nm, 210 nm, 266 nm, 365 nm, 405 nm, 488 nm, 532 nm, 633 nm, 650 nm, 680 nm, 780 nm, and 830 nm.

The laser beam may be a continuous light beam or pulsed light beam. However, it is preferable to use a laser beam whose emission intervals can be changed freely. For example, the use of a semiconductor laser is preferable. In the case where the laser beam is not directly on-off keyed, it is preferable that the laser beam is modulated using an external modulation element.

In order to increase the processing speed, a higher laser power is preferable. However, the higher the laser power, the higher scanning speed (speed for scanning the photoresist layer with the laser beam; for example, rotation speed of the rotary stage 55 in the above-described embodiment) is required. For this reason, taking the upper limit value of the scanning speed into consideration, the upper limit value of the laser power is preferably 100 W, more preferably 10 W, and still more preferably 5 W, and most preferably 1 W. Meanwhile, the lower limit value of the laser power is preferably 0.1 mW, more preferably 0.5 mW, and still more preferably 1 mW.

It is preferable that the laser beam has a narrow range of oscillation wavelength and excels in coherency, and that the laser beam can be condensed to a spot size which is as small as the wavelength of the laser beam.

Further, it is preferable that the thickness t of the photoresist layer and the diameter d of the pit has the following relationship. Namely, the upper limit value of the thickness t of the photoresist layer preferably takes a value to satisfy the relationship as given by t<10d, more preferably takes a value to satisfy t<5d, and still more preferably to satisfy t<3d. The lower limit value of the thickness t of the photoresist layer preferably takes a value to satisfy the relationship as given by t>d/100, more preferably takes a value to satisfy t>d/10, and still more preferably to satisfy t>d/5. If the upper limit and lower limit values of the thickness t of the photoresist layer relative to the diameter d of the pit have the aforementioned relationships, the advantages similar to those described above such as the desired effect as etching mask and increased processing speed can be achieved.

### EXAMPLE

Next, one example implemented to verify the advantageous effects of the present invention will now be described.

As an example, the photoresist material given by the following formula was dissolved in a TFP (tetrafluoropropanol) solvent at a concentration of 20 mg/ml to prepare an application liquid, and the resulting application liquid was applied on a silicon substrate having a diameter of 4 inches (approximately 10 cm) by spin coating. A photoresist layer having a thickness of 100 nm was formed.

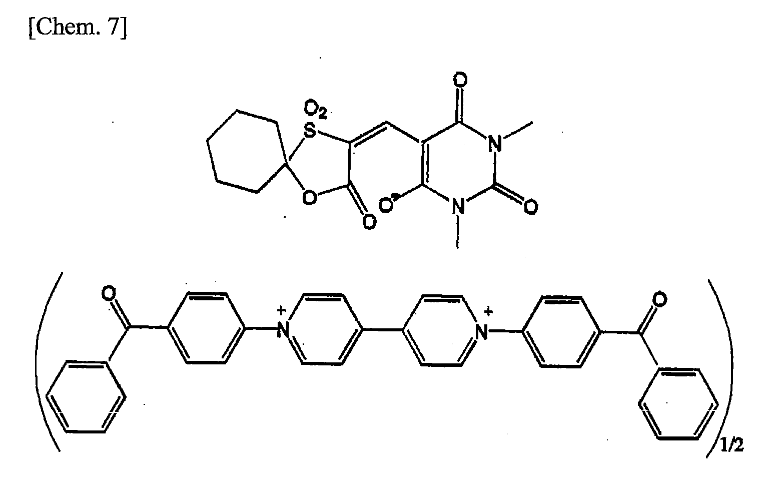

The photoresist layer was exposed to a laser beam in accordance with a manufacturing method similar to that described in the above embodiment, so that a plurality of pits were formed on the photoresist layer.

NEO1000 (manufactured by Pulstec Industrial Co., Ltd.) was used as an exposure device, and a plurality of pits were formed under the following conditions as shown in Table 1 below. In Table 1, each value of the land height shown in percentage terms indicates a ratio to the thickness (100 nm) of the photoresist layer.

As a result, Examples 1-3 showed that a higher land height can be achieved in the rage of 10-40% duty cycle. However, when the linear velocity was as small as 4 m/s, heat stayed in the photoresist layer and the land height became lower.

**[Table 1]**

| | | Example 1 | Comparative Example 1 | Comparative Example 2 | Example 2 | Comparative Example 3 | Example 3 |
|---|---|---|---|---|---|---|---|
| Laser Output | mW | 8 | 20 | 8 | 4 | 32 | 16 |
| Duty Cycle | % | 20 | 20 | 20 | 40 | 50 | 10 |
| Linear Velocity | m/s | 10 | 4 | 4 | 10 | 10 | 10 |
| Land Heiglt | nm | 70 | 10 | 15 | 45 | 25 | 60 |
| | % | 70 | 10 | 15 | 45 | 25 | 60 |

## Claims

1. A method for manufacturing a patterned member, on which a dotted pattern is formed, comprising:
a preparation step of preparing a substrate having a photoresist layer which undergoes a change in shape when it is illuminated and hence heated with an electromagnetic beam; and
an exposure step of illuminating and scanning the photoresist layer with the electromagnetic beam to remove a part of the photoresist layer,
wherein in the exposure step, an emission time of the electromagnetic beam is adjusted to fall within 10-40% of a scanning time corresponding to a pitch of a plurality of pits formed on the photoresist layer in a scanning direction.

2. The method for manufacturing a patterned member according to claim 1, wherein the photoresist layer is scanned with the electromagnetic beam at a liner velocity in the range of 6-200 m/s.

3. The method for manufacturing a patterned member according to claim 1 or 2, further comprising, after the exposure step, an etching step of etching the substrate using the photoresist layer as a mask.

4. The method for manufacturing a patterned member according to claim 1 or 2, further comprising the following steps performed after the exposure step:
a film formation step of forming a film on the substrate at positions where the substrate is exposed to view through a plurality of pits of the photoresist layer; and
a removal step of removing the photoresist layer.

5. The method for manufacturing a patterned member according to claim 1, wherein the thickness of the photoresist layer is set in the range of 1-10000 nm.

6. The method for manufacturing a patterned member according to claim 1, wherein the photoresist layer comprises at least one dye selected from a group consisting of monomechine cyanine dyes, monomechine oxonol dyes, phthalocyanine dyes, azo dyes, azo-metal complex dyes, porphyrin dyes, arylidene dyes, coumarin dyes, azole derivatives, triazine derivatives, benzotriazole derivatives, 1-aminobutadiene derivatives, and quinophthalone dyes.

7. The method for manufacturing a patterned member according to claim 1, wherein an output of the electromagnetic beam is set in the range of 4-200 mW.

8. A processing apparatus using an electromagnetic beam for manufacturing a patterned member, on which a dotted pattern is formed, comprising:
a holder configured to support a substrate having a photoresist layer which undergoes a change in shape when it is illuminated and hence heated with an electromagnetic beam;
a beam source configured to emit the electromagnetic beam;
a scanning means configured to scan the photoresist layer with the electromagnetic beam emitted from the beam source; and
a controller configured to execute a control to effect a change in an output of the electromagnetic beam emitted from the beam source,
wherein the controller causes the beam to be emitted for an emission time in the range of 10-40% of a scanning time corresponding to a pitch of a plurality of pits formed on the photoresist layer in a scanning direction to form a plurality of dot-like pits on the photoresist layer.
